(19) Europäisches Patentamt
European Patent Office
Office européen des brevets

(11) Publication number: **0 123 262**
**A2**

(12) # EUROPEAN PATENT APPLICATION

(21) Application number: 84104362.3

(22) Date of filing: 17.04.84

(51) Int. Cl.³: H 01 L 23/30
H 01 L 23/28, H 01 L 21/56

(30) Priority: 22.04.83 JP 71877/83

(43) Date of publication of application:
31.10.84 Bulletin 84/44

(84) Designated Contracting States:
DE FR GB NL

(71) Applicant: HITACHI, LTD.
6, Kanda Surugadai 4-chome Chiyoda-ku
Tokyo 100(JP)

(72) Inventor: Ono, Masahiro
Tozawa-ryo, 3-10-12 Suehiro-cho
Hitachi-shi Ibaraki-ken(JP)

(72) Inventor: Takahashi, Akio
3595, Kanai-cho
Hitachi-shi Ibaraki-ken(JP)

(72) Inventor: Tada, Ritsuo
604-26, Senba-cho
Mito-shi Ibaraki-ken(JP)

(72) Inventor: Wajima, Motoyo
1-8-8, Higashiohnuma-cho
Hitachi-shi Ibaraki-ken(JP)

(72) Inventor: Narahara, Toshikazu
409-5, Muramatsu
Toukai-mura Naka-gun Ibaraki-ken(JP)

(72) Inventor: Kitamura, Masahiro
2-29-12, Higashiohnuma-cho
Hitachi-shi Ibaraki-ken(JP)

(72) Inventor: Ogata, Masatsugu
2-15-43, Mizuki-cho
Hitachi-shi Ibaraki-ken(JP)

(72) Inventor: Takada, Yukihiko
921-2, Takeda
Katsuta-shi Ibaraki-ken(JP)

(74) Representative: Strehl, Peter, Dipl.-Ing. et al,
Strehl, Schübel-Hopf, Schulz Patentanwälte
Widenmayerstrasse 17 Postfach 22 03 45
D-8000 München 22(DE)

(54) **Resin encapsulated semiconductor device and process for producing the same.**

(57) The resin encapsulated semiconductor device having improved moisture resistance and thermal stability is provided with a resin encapsulation and/or resin coating of a resin material containing isomelamine rings and melamine rings.

FIG. 1

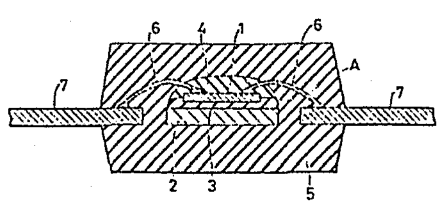


EP 0 123 262 A2

./...

The isomelamine ring and melamine ring herein are represented by the following formulae [I] and [II], respectively:

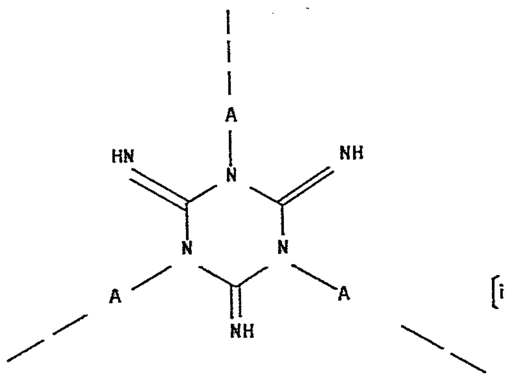

[I]
[isomelamine ring]

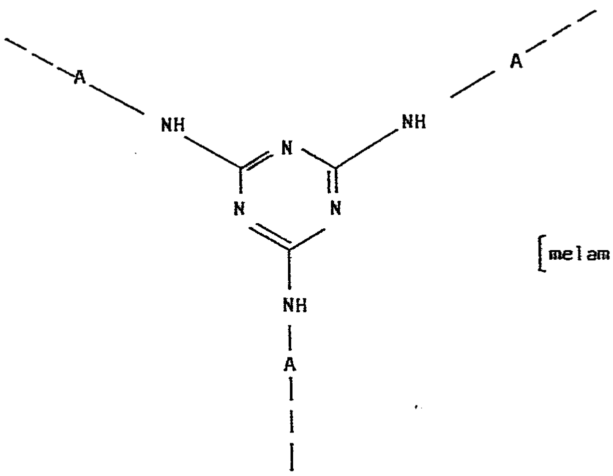

[II]
[melamine ring]

The starting materials for the above-mentioned polymers include polycyanamide compounds selected from the group consisting of aromatic cyanamide compounds and N-cyano-N-amide compounds.

HITACHI, LTD.
EPA-26 479

0123262

SPECIFICATION

Title of the Invention:

RESIN ENCAPSULATED SEMICONDUCTOR DEVICE AND PROCESS FOR PRODUCING THE SAME

The present invention relates to resin-encapsulated electronic parts such as semiconductor devices, for example, diodes, transistors, IC and LSI and a process for producing them.

There have been known semiconductor devices produced by encapsulating a semiconductor element to a substrate or base plate comprising a metallic material or a ceramic material by using a synthetic adhesive, coating the surface of the semiconductor element with a protective film and sealing them with a resin or a glass. As typical surface-protective films, polyimide resin films or silicone gel films have been recommended. However, these semiconductor devices have an insufficient moisture resistance. This problem is serious particularly in semiconductors of which a long time reliability is required or semiconductors used ina semiconductor device having a high wiring density of which a high reliability is required. When a semiconductor device having a poor moisture

resistance is used, aluminum (Al) wires, electrodes or bonding parts are corroded and the wires are broken.

## Summary of the Invention

An object of the present invention is to provide resin-encapsulated semiconductor devices having improved moisture resistance and thermal stability.

The semiconductor device of the present invention comprises a semiconductor element having a surface-protective film and a resin material for encapsulating the same, wherein the protective film is made of a thermosetting polymer material containing isomelamine rings and melamine rings.

The inventors have found that a polymer having the following particular chemical structures has a quite excellent adhesive property to semiconductor elements. Further, the inventors have found that when this polymer is used in forming a surface-protective film for the semiconductor element, the moisture resistance of the semiconductor device can be improved remarkably.

## Brief Description of Drawings

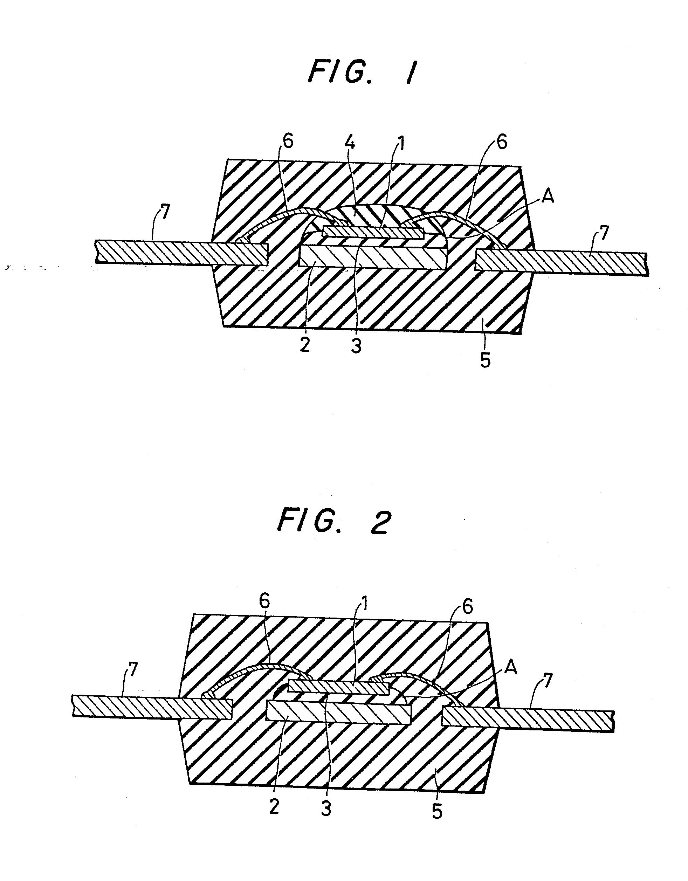

Fig. 1 and 2 are cross sections of embodiments of the semiconductor devices of the present invention.

## Detailed Description of the Invention

The isomelamine ring and melamine ring herein are represented by the following formulae [I] and [II], respectively:

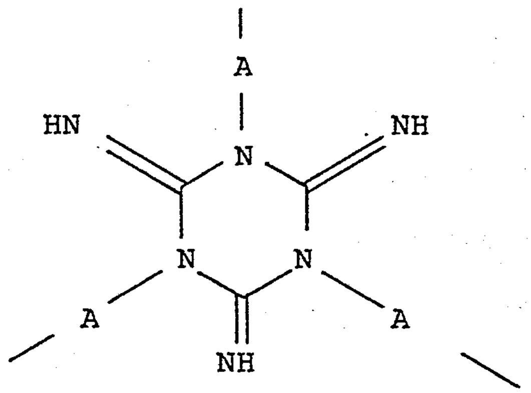

[I]

isomelamine ring

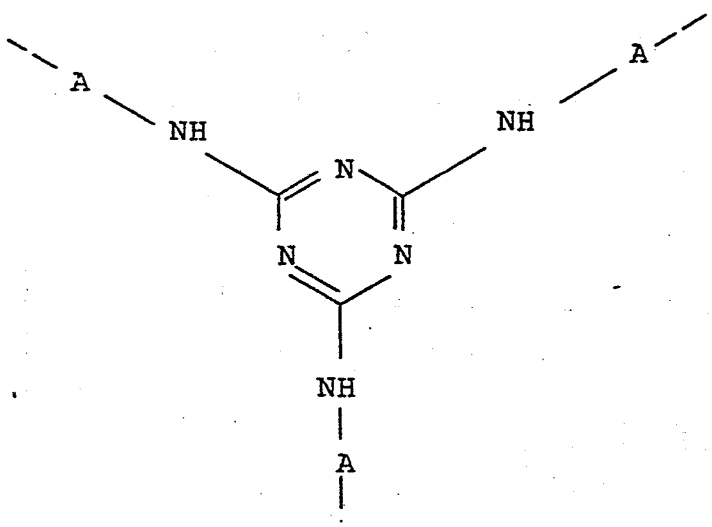

[II]

melamine ring

The starting materials for the above-mentioned polymers include polycyanamide compounds selected from the group consisting of aromatic cyanamide compounds and N-cyano-N-amide compounds. The above-mentioned polymers can be obtained by

heating at least one of these compounds.

The aromatic cyanamide compounds include, for example, phenyl cyanamide, 2,6-dicyanamidopyridine, m-phenylene dicyanamide, p-phenylene dicyanamide, 4,4'-dicyanamidodiphenylmethane, 2,2'-bis(4-cyanamidodiphenyl)propane, 4,4'-dicyanamidodiphenyl oxide, 4,4'-dicyanamidodiphenyl sulfone, bis(4-aminophenyl)phenylphosphine oxide, bis(4-cyanamidophenyl)-methylamine, 1,5-dicyanamidonaphthalene, m-xylylene dicyanamide, 1,1-bis(p-cyanamidophenyl)phthalan, p-xylylene dicyanamide, hexamethylene dicyanamide, 6,6'-dicyanamido-2,2'-dipyridyl, 4,4'-dicyanamidobenzophenone, 4,4'-dicyanamidoazobenzene, bis(4-cyanamidophenyl)cyclohexane, 1,1-bis(4-cyanamido-3-methylphenyl)-1,3,4-oxadiazole, 4,4'-dicyanamidodiphenyl ether, 4,4'-bis(p-cyanamidophenyl)-2,2'-dithiazole, m-bis(4-p-cyanamidophenyl-2-thiazolyl)-benzene, 4,4'-dicyanamido-benzanilide, 4,4'-dicyanamidophenyl benzoate, 2,2'-bis[4-(4-cyanamidophenoxy)phenyl] propane, 2,2'-bis[3-methyl-4-(4-cyanamidophenoxy)phenyl] propane, 2,2-bis[3-ethyl-4-(4-cyanamidophenoxy)phenyl] propane, 2,2-bis [3-propyl-4-(4-cyanamidophenoxy)phenyl] propane, 2,2-bis [3-isopropyl-4-(4-cyamamidophenoxy)phenyl] propane, bis[4-(4-cyanamidophenoxy)-phenyl] methane and cyanamido-terminated sulfone ether oligomers and polyphenylmethylene polycyanamides of the following formula [III] :

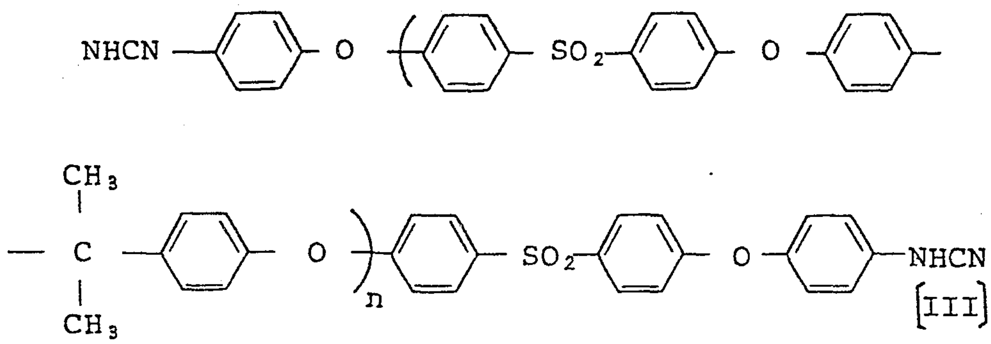

[III]

wherein n is 0 to 3.

The N-cyano-N-amide compounds include, for example, those of the following general formulae:

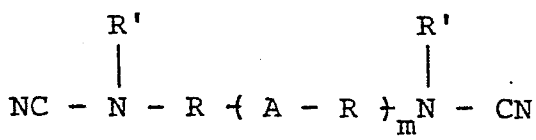

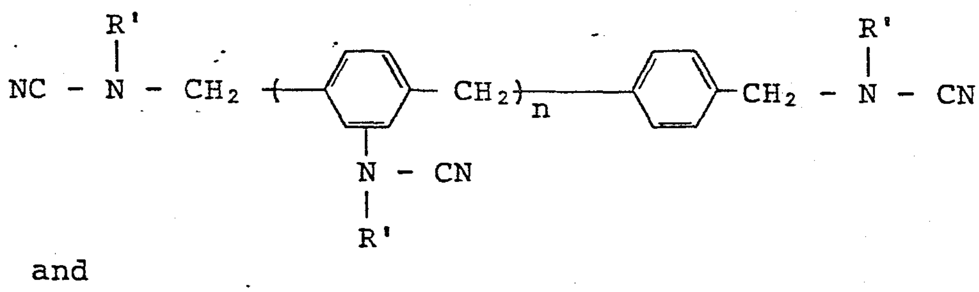

and

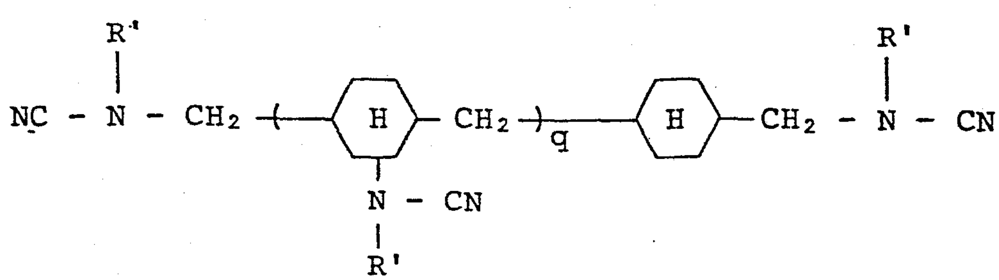

wherein R' represents a hydrogen atom, a benzenesulfonyl group, a benzenecarbonyl group or a benzyl group and at least one R' in the molecule represents a hydrogen atom, R represents an alkylene group having 4 to 14 carbon atoms, a cycloalkylene group or a phenylene group, A represents O, S, $SO_2$, CO or $CH_2$, m represents a number of 0 or 1, n represents a number of 0 to 3 and q represents a number of 0 to 4.

In the present invention, a polymerizable compound may be used together with the above-mentioned polycyanamide compound. The polymerizable compounds include, for example, aromatic diamines such as 4,4'-diaminodicyclohexylmethane, 1,4-diaminocyclohexane, 2,6-diaminopyridine, m-phenylenediamine, p-phenylenediamine, 4,4'-diaminodiphenylmethane, 2,2'-bis(4-aminophenyl)propane, benzidine, 4,4'-diaminodiphenyl oxide, 4,4'-diaminodiphenyl sulfone, bis(4-aminophenyl)-methylphosphine oxide, bis(4-aminophenyl)phenylphosphine oxide, bis(4-aminophenyl)methylamine, 1,5-diaminonaphthalene, m-xylylenediamine, 1,1-bis(p-aminophenyl)phthalan, 6,6'-diamino-2,2'-dipyridyl, 4,4'-diaminobenzophenone, 4,4'-diaminoazobenzene, bis(4-aminophenyl)phenylmethane, 1,1-bis-(4-aminophenyl)cyclohexane, 1,1-bis(4-amino-3-methylphenyl)-cyclohexane, 2,5-bis(m-aminophenyl)-1,3,4-oxadiazole, 2,5-bis(p-aminophenyl)-1,3,4-oxadiazole, 2,5-bis(m-aminophenyl)-thiazolo(4,5-d)thiazole, 5,5-di(m-aminophenyl)-(2,2')-bis-(1,3,4-oxadiazolyl), 4,4'-diaminodiphenyl ether, 4,4'-bis-(p-aminophenyl)-2,2'-dithiazole, m-bis(4-p-aminophenyl-2-thiazolyl)benzene, 4,4'-diaminobenzanilide, 4,4'-diaminophenyl benzoate, N,N'-bis(4-aminobenzyl)-p-phenylenediamine, 4,4'-methylenebis(2-dichloroaniline), benzoguanamine and methylguanamine.

The polymerizable compounds include also difunctional epoxy compounds such as diglycidyl ether of bisphenol A, 3,4-epoxycyclohexylmethyl 3,4-epoxycyclohexanecarboxylate, 4,4'-(1,2-epoxyethyl)diphenyl ether, resorcinol diglycidyl either, bis(2,3-epoxycyclopentyl) ether and N,N'-m-phenylenebis(4,5'-epoxy-1,2-cyclohexanedicarbodiimide); trifunctional or polyfunctional epoxy compounds such as triglycidyl compounds of p-aminophenol, 1,3,5-tri(1,2-epoxyethyl)benzene, tetraglycidoxytetraphenylethane and polyglycidyl ethers of phenolformaldehyde novolak resin; and epoxy compounds containing halogen atoms such as brominated epoxy compounds.

Further, the polymerizable compounds include bismaleimide compounds such as N,N'-methylenebismaleimide, N,N'-ethylenebismaleimide, N,N'-hexamethylenebismaleimide, N,N'-trimethylenebismaleimide, N,N'-m-phenylenebismaleimide, N,N'-4,4'-diphenylmethanebismaleimide, N,N'-4,4'-diphenylmethanebismaleimide, N,N'-diphenyl ether bismaleimide, N,N'-methylenebis-(3-chloro-p-phenylene)bismaleimide, N,N'-4,4'-diphenyl sulfone bismaleimide, N,N'-4,4'-dicyclohexylmethanebismaleimide, N,N'-α,α'-4,4'-dimethylenecyclohexanebismaleimide and N,N'-4,4'-diphenylcyclohexanebismaleimide; and polymaleimides of the following formula [IV] obtained by reacting a condensate of aniline and formaldehyde with maleic anhydride:

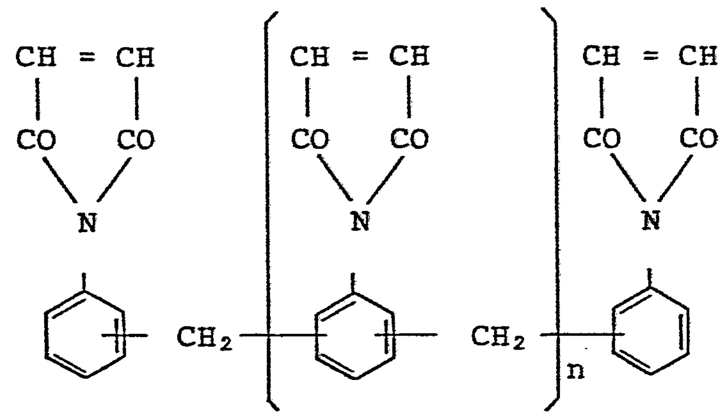

[IV]

The following monomaleimide compounds may also be used in the present invention: N-methylmaleimide, N-ethylmaleimide, N-propylmaleimide, N-butylmaleimide, N-allylmaleimide, N-vinylmaleimide, N-phenylmaleimide, N-3-chlorophenylmaleimide, N-o-tolylmaleimide, N-m-tolylmaleimide, N-p-tolylmaleimide, N-o-methoxyphenylmaleimide, N-m-methoxyphenylmaleimide, N-p-methoxyphenylmaleimide, N-benzylmaleimide, N-pyridylmaleimide, N-hydroxyphenylmaleimide, N-acetoxyphenylmaleimide, N-dichlorophenylmaleimide, N-benzophenonemaleimide, N-diphenyl ether maleimide, N-acetylphenylmaleimide and N-cyclohexylmaleimide.

The following phenolic compounds may also be used in the present invention: phenol, cresol, m-cresol, p-cresol, 2,5-xylenol, 2,6-xylenol, o-chlorophenol, m-chlorophenol, p-chlorophenol, o-phenylphenol, m-phenylphenol, p-phenylphenol, saligenin and bisphenol A.

In addition, polybutadiene, triallyl isocyanurate, acrylic acid compounds, guanamines and melamine may be used in the invention.

The above-mentioned polymerizable compounds may be used either alone or in the form of a mixture of two or more of them in the present invention.

The present invention will now be described with reference to attached drawings. Fig. 1 is a cross section of an embodiment of the semiconductor device of the present invention. In Fig. 1, a semiconductor element 1 is sealed to and bonded with a substrate or supporting body 2 by means of an adhesive 3. Further, the surface of the semiconductor element 1 is coated with a surface-protective film 4 comprising a polymer containing the above-mentioned isomelamine rings and melamine rings. They are encapsulated by a molding resin 5 comprising a thermosetting resin. Numeral 6 is lead wire and 7 is a lead. The semiconductor element 1 comprises, for example, an integrated circuit element. Wires of, for example, aluminum (not shown) and output electrodes (not shown) are arranged on the principal surface of the element. The molding resin 5 can be formed by, for example, a known molding technique such as a transfer molding process.

The surface-protective film herein is formed on the

surface of the semiconductor element (chip) for fulfilling at least one of the purposes of stabilizing the junction, shielding α-rays and reducing a stress caused by the molding resin.

After further investigations, the inventors have recognized that when the same polymer as that used in the formation of the surface-protective film 4 is used as the molding resin 5, the adhesive power on the interface between the sealer 5 and the surface-protective film 4 is increased to contribute to the improvement in the moisture resistance. In this connection, the surface-protective film 4 may be formed in another step than that of forming the molding resin 5. When α-ray shielding effects are required, it is preferred to incorporate a filler having a high purity in the resin. It is also possible to directly mold the encapsulating resin 5 and the surface-protective film 4 integrally, omitting the step of forming the surface-protective film 4. Namely, the molding resin or encapulating resin 5 may serve also as the surface-protective film as shown in Fig. 2.

The inventors have found further that when the polymer containing the above-mentioned isomelamine rings and melamine rings is used also as the adhesive 3 shown in Figs. 1 and 2, a semiconductor device having not only a high heat resistance but also a quite high moisture resistance can be obtained. A reason therefor may be as follows: when the adhesive has a

poor heat resistance, decomposition products of the adhesive are formed in a very small amount in a wire bonding step (350°C) and they stain the conductor element and the substrate. Therefore, when they are encapsulated in the molding material, the adhesion between the semiconductor element and the substrate and the molding material is poor and, consequently, water is absorbed therein at the interface to cause a corrosion. Accordingly, a polyimide resin having a high heat resistance has been used as the adhesive in the prior art. However, such a resin requires a specified solvent having a high boiling point, such as N-methyl-2-pyrrolidone. Such a high boiling solvent still remains in the adhesive after the hardening to form microvoids in the adhesive. Water comes into the voids and the adhesive power is reduced due to the presence of the voids. When a conventional heat-resistant resin is used, a high temperature of 200 to 300°C and a long time of at least 60 minutes are required for the hardening. As described above, the above-mentioned polycyanamide compound may be used as the starting material for the adhesive of the present invention. The polycyanamide compound or a composition comprising the same and another polymerizable compound is hardened immediately (10 to 600 seconds at 150 to 300°C) and the hardened product has an extremely high heat resistance. Further, a solvent having a low boiling point used generally in the prior art may be used in the present

invention. Therefore, the solvent does not remain in the adhesive in the hardening step and no voids are formed. The water absorption through the voids is only negligible. Gaseous low-molecular organic compounds containing C, H and O elements, etc. formed in the step of curing the adhesive by heating deposits on the surface of the semiconductor element and the resulting deposits lower the adhesion between the molding and the surface of the semiconductor element. When extraneous water penetrates therein under the circumstance, the surface of the semiconductor element is easily separated from the surface of the molding resin to form voids. Thus, the corrosion of the Al wires or bonding parts is accelerated. According to the present invention, such a problem can be avoided.

As the amount of the isomelamine and melamine rings of the above formula [I] or [II] formed is increased, the state of the polymer used in the present invention changes gradually as follows: state A → state B → state C. State B corresponds to a prepolymer which can be obtained by a preliminary reaction. In using the polymer as a varnish, it is in state A or state B. In the present invention, the polycyanamide compound or the composition containing this compound and another polymerizable compound (the compound or the composition will be referred to as "the starting compound" hereinafter) is reacted and cured by heating the same in an organic

solvent or in the absence of any solvent. The latter is a so-called fusion reaction. When the solvent is used, it is preferred to carry out the reaction by heating the reactant first to about 50 to 150°C and then to a higher temperature of about 150 to 220°C. On the other hand, the fusion reaction can be carried out by heating to a relatively high temperature of a about 150 to 220°C in the initial stage. The prepolymer can be obtained by terminating the heating when the reaction product in B-stage is obtained. When the reaction is carried out in the solvent, the heating is terminated before a solid (cured product) is precipitated. In the present invention, the cured product may be obtained directly without suspending the reaction in the B-stage. The solvents include, for example, methyl ethyl ketone, methyl acetyl ketone, 2-methoxyethanol, 2-(methoxymethoxy)-ethanol, 2-isopropoxyethanol, 2-(ethoxyethoxy)ethanol, dioxane, dimethyldioxane, monopropylene glycol methyl ether, N,N-dimethylformamide, N,N'-dimethylacetamide and N-methyl-2-pyrrolidone. These solvents may be used either alone or in the form of a mixture of two or more of them.

It is most effective in the present invention to use the above-mentioned surface-protective film, molding resin and adhesive in their stage B (i.e. in the form of the prepolymer). Particularly, the surface-protective film and the adhesive are used preferably in the form of a solution of

the prepolymer in a solvent. The prepolymer solution has a quite excellent film-forming ability far superior to that of a conventional polyimide resin. For example, it has a uniform film thickness, that is, hardly foamed, and a thick films thereof can be formed easily. Particularly, a sufficiently thick film can be formed by a single coating operation. When the conventional polyimide resin is used, the application (coating) and a heat treatment at about 200°C must be repeated several times. Further, for the final curing of the polyimide resin, a heat treatment at a temperature of as high as 300 to 400°C for a time of as long as about 1 to 2 hours is required and, therefore, its processability is unsatisfactory. In addition, the characteristics of the semiconductor devices are changed frequently by the heat treatment effected at such a high temperature for such a long time. Another problem of the polyimide resin is its poor adhesion to the semiconductor element (chip). On the other hand, the above-mentioned prepolymer solution used in the present invention is rapidly curable (150 to 300°C in 10 seconds to 30 minutes). Thus, the characteristics of the semiconductor devices of the present invention are not damaged, since it can be cured at a low temperature in a short period of time.

A known inorganic filler and other additives may be incorporated into not only the molding resin but also the

surface-protective film and the adhesive. Further, an electroconductive powder such as silver powder may also be incorporated into the adhesive so as to produce a conductive adhesive. In this case, the substrate or supporting body may serve as a ground level.

Detailed Examples of the Invention

Example 1

a) 4,4'-dicyanamidodiphenylmethane
80 parts by weight

b) 4,4'-diaminodiphenylmethane
20 parts by weight

The above two compounds were dissolved in 100 parts by weight of methyl ethyl ketone. The solution was prereacted at 60 to 80°C for 60 min to obtain a prepolymer.

Example 2

a) 4,4'-dicyanamidodiphenyl ether
70 parts by weight

b) 4,4'-diaminodiphenylmethane
30 parts by weight

The above two compounds were dissolved in 100 parts by weight of methyl ethyl ketone. The solution was prereacted at 60 to 80°C for 30 min to obtain a prepolymer.

Example 3

4,4'-dicyanamidodiphenylmethane

100 parts by weight

This compound was dissolved in 100 parts by weight of methyl ethyl ketone. The solution was prereacted at 60 to 80°C for 60 min to obtain a prepolymer.

Example 4

a) 4,4'-dicyanamidodiphenylmethane

80 parts by weight

b) bisphenol A-type epoxy resin

20 parts by weight

These two compounds were dissolved in 10 parts by weight of butyl cellosolve. The solution was prereacted at 60 to 80°C for 30 min to obtain a prepolymer.

Conventional Example 1

a) 4,4'-bis(p-aminophenoxy)biphenyl

50 parts by weight

b) pyromellitic dianhydride

30 parts by weight

These two compounds were dissolved in 450 parts by weight of N-methyl-2-pyrrolidone. They were reacted at about 10°C for 5 h to obtain a prepolymer.

Conventional Example 2

a) bisphenol A-type epoxy resin

100 parts by weight

b) phenolic novolak resin

50 parts by weight

c) 2-ethyl-4-methylimidazole

2 parts by weight

These three compounds were dissolved in 100 parts by weight of methyl ethyl ketone and stirred at 50 to 60°C for about 15 min to obtain a prepolymer.

The surface-protective film-forming prepolymers obtained in the above Examples 1 to 4 and Conventional Examples 1 to 2 were applied to MOS 64 K bit D-RAM elements and curing conditions of them were examined. Then, the elements having the coating films were subjected to PCT (a test wherein the samples are left to stand in steam at 120°C under 2 bar (2 atm) for 1000 h. The adhesion between the element and the surface-protective film was examined with a lead checking liquor. The results are shown in Table 1.

Table 1

| | Hardening conditions | | | | | | Adhesion between the element and the protective film PCT (h) |
|---|---|---|---|---|---|---|---|
| | Primary hardening | | Secondary hardening | | Secondary hardening | | |
| | Temp. (°C) | Time (h) | Temp. (°C) | Time (h) | Temp. (°C) | Time (h) | |
| Ex. 1 | 100 | 0.5 | 250 | 0.5 | Unnecessary | | at least 1000 |
| Ex. 2 | 100 | 0.5 | 250 | 0.5 | " | | at least 1000 |
| Ex. 3 | 100 | 0.7 | 250 | 0.5 | " | | at least 1000 |
| Ex. 4 | 100 | 0.7 | 250 | 0.5 | " | | at least 1000 |
| Conventional Ex. 1 | 100 | 1.0 | 250 | 1.0 | 350 | 1.0 | 100 |
| Conventional Ex. 2 | 100 | 0.5 | 200 | 0.3 | Unnecessary | | 300 |

Note: Adhesion between the element and the protective film:

The surface of MOS 64 K bit D-RAM memory LSI element was coated with each sample and the element was subjected to PCT (a test wherein the sample is left to stand in steam at 120°C under 2 atm). The peeling of the coating film from the element was examined with a lead checking liquor. The results are shown by PCT time judged from dyeing of the element surface in red and peeling.

It is apparent from Table 1 that the surface-protective film of the present invention was curable under conditions comprising a lower temperature and a longer time as those of the conventional coating films and that the former had an extremely high adhesion to the element.

Example 5

a) 4,4'-dicyanamidodiphenylmethane

100 parts by weight

b) butyl cellosolve

100 parts by weight

c) silver powder (average particle diameter: 1.2 μ)

350 parts by weight

These components a) and b) were stirred in a 300 mℓ flask provided with a reflux condenser at 60 to 80°C for 90 min to obtain a homogeneous prepolymer solution. Then, the solution was charged in a 1 ℓ mortar. Component c) was charged therein in the given amount and stirred by means of an automatic masticator for about 2 h to obtain an adhesive containing the silver powder.

Example 6

a) 4,4'-dicyanamidodiphenylmethane

80 parts by weight

b) 4,4'-diaminodiphenylmethane

20 parts by weight

c) butyl cellosolve

100 parts by weight

d) silver powder (average particle diameter: 1.2 μm)

350 parts by weight

The components a) to c) were stirred in a 300 mℓ flask provided with a reflux condenser at 60 to 80°C for 40 min to obtain a homogeneous solution. The solution was charged in a 1 ℓ mortar. The given amount of the component d) was charged therein and they were stirred by means of an automatic masticator for about 2 h to obtain an adhesive containing the silver powder.

Example 7

a) 4,4'-dicyanamidodiphenylmethane

70 parts by weight

b) N,N'-4,4'-diphenylmethanebismaleimide

30 parts by weight

c) N-methyl-2-pyrrolidone

100 parts by weight

d) silver powder (average particle diameter: 3.0 μm)

480 parts by weight

The above components a) to c) were stirred in a 300 mℓ flask provided with a reflux condenser at 70 to 90°C for 90 minutes to obtain a homogeneous solution. Then, the solution

was changed in a 1 ℓ mortar. The given amount of the component d) was charged therein and stirred by means of an automatic masticator for about 2 h to obtain an adhesive containing the silver powder.

Conventional Example 3

a) bisphenol A-type epoxy resin
100 parts by weight

b) tetrahydrophthalic anhydride
52 parts by weight

c) butyl cellosolve
100 parts by weight

d) 2-ethyl-4-methylimidazole
2 parts by weight

e) silver powder (average particle diameter: 1.2 μm)
600 parts by weight

f) epoxysilane
2 parts by weight

The above components a) to c) were stirred in a 500 mℓ flask provided with a reflux condenser at 60 to 80°C for 30 minutes to obtain a homogeneous solution. Then, the solution was charged in a 1 ℓ mortar. The given amounts of the components d) to f) were charged therein and stirred by means of an automatic masticator for about 2 h to obtain an adhesive containing the silver powder.

Conventional Example 4

a) bisphenol A-type epoxy resin

100 parts by weight

b) phenolic novolak resin

50 parts by weight

c) butyl cellosolve

100 parts by weight

d) 2-ethyl-4-methylimidazole

2 parts by weight

e) silver powder (average particle diameter: 1.2 μm)

600 parts by weight

f) epoxysilane

2 parts by weight

The above components a) to c) were stirred in a 500 mℓ flask provided with a reflux condenser at 60 to 80°C for 60 min to obtain a homogeneous solution. Then, the solution was charged in a 1 ℓ mortar. The given amounts of the components d) to f) were charged therein and stirred by means of an automatic masticator for about 2 h to obtain an adhesive containing the silver powder.

A model element having the same size as that of the MOS 64K bit D-RAM element was adhered to a 42 alloy lead frame material with each of the adhesives obtained in Examples 5 to 7 and Conventional Examples 3 and 4. The adhesion

processability (curing conditions) are shown in Table 2. Then, the adhesion between the model element and the frame material bonded with the adhesive was examined by means of a push-pull gauge. The results are shown in Table 2. The adhesive power was measured in the initial stage, after the heat treatment at 350°C (i.e. a temperature to which the element was exposed in the wire bonding step) for 15 minutes and after the moisture resistance test (PCT 200 h).

Table 2

| | Curing conditions | | Adhesive power ($kg/mm^2$) | | |
|---|---|---|---|---|---|
| | Temp. (°C) | Time (min) | Initial value | After heat treatment at 350°C for 15 min | After PCT for 200 h |
| Example 5 | 250 | 0.4 | 14.0 | 13.5 | 14.0 |
| Example 6 | 250 | 0.4 | 14.3 | 14.0 | 14.2 |
| Example 7 | 250 | 0.4 | 16.0 | 15.5 | 16.0 |
| Conventional Example 3 | 250 | 30 | 0.8 | 0 | 0 |
| Conventional Example 4 | 250 | 30 | 2.0 | 0.5 | 0.2 |

Note: Adhesive power was determined by adhering a model element on a 42 alloy lead frame material with each adhesive and then the adhesive power between them was measured by means of a push-pull gauge.

It is apparent from Table 2 that the adhesive of the present invention has a higher processability (shorter curing

time) than that of the conventional material and the former has a higher adhesive power even at a high temperature and a higher moisture resistance.

Conventional Example 5

Composition:

a) cresol novolak-type epoxy resin
100 parts by weight

b) phenolic novolak resin
50 parts by weight

c) 2-heptadecylimidazole
2 parts by weight

d) Hoechst Wax E
2 parts by weight

e) carbon black
1 part by weight

f) epoxysilane KBM 403
2 parts by weight

g) quartz glass powder
300 parts by weight

The above components a) to g) were kneaded in an 20.3 cm mixing roll heated to 80 to 90°C for 3 to 10 minutes, then cooled and pulverized to obtain a molding material.

Conventional Example 6

Composition:

a) cresol novolak-type epoxy resin

100 parts by weight

b) tetrahydrophtalic anhydride

50 parts by weight

c) 2-heptadecylimidazole

2 parts by weight

d) Hoechst Wax E

2 parts by weight

Example 8

Composition:

a) 4,4'-dicyanamidodiphenylmethane

80 parts by weight

b) 4,4'-diaminodiphenylmethane

20 parts by weight

c) stearic acid

2 parts by weight

d) carbon black

1 part by weight

e) epoxysilane

2 parts by weight

f) quartz glass powder

200 parts by weight

The above components a) to f) were kneaded by fusion by means of an 20.3 cm mixing roll heated to 80 to 90°C for 10 minutes, then cooled and pulverized to obtain a molding material.

Example 9

Composition:

a) 4,4'-dicyanamidodiphenylmethane
50 parts by weight

b) cresol novolak-type epoxy resin
50 parts by weight

c) 2-heptadecylimidazole $C_{17}Z$
(a product of Shikoku Kasei Co.)
1 part by weight

d) Hoechst Wax E
2 parts by weight

e) carbon black
1 part by weight

f) epoxysilane
2 parts by weight

g) quartz glass powder
200 parts by weight

The above components a) to g) were kneaded by fusion by means of an 20.3 cm mixing roll heated to 80 to 90°C for 3 to 10 minutes, then cooled and pulverized to obtain a molding material .

Example 10

Composition:

a) 4,4'-dicyanamidodiphenylmethane
30 parts by weight

0123262

b) cresol novolak-type epoxy resin

50 parts by weight

c) phenolic novolak resin

20 parts by weight

d) triphenylphosphine

2 parts by weight

e) Hoechst Wax E (a product of Hoechst Japan)

2 parts by weight

f) carbon black

1 part by weight

g) epoxysilane

2 parts by weight

h) quartz glass powder

200 parts by weight

The above components a) to h) were kneaded by fusion by means of an 20.3 cm mixing roll heated to 80 to 90°C for 3 to 10 minutes, then cooled and pulverized to obtain a molding material.

Example 11

Composition:

a) 4,4'-dicyanamidodiphenylmethane

70 parts by weight

b) N,N'-4,4'-diphenylmethanebismaleimide

30 parts by weight

c) Hoechst Wax

2 parts by weight

d) carbon black

1 part by weight

e) epoxysilane

2 parts by weight

f) quartz glass powder

200 parts by weight

The above components a) to f) were kneaded by fusion by means of an 20.3 cm mixing roll heated to 80 to 90°C for 3 to 10 minutes, then cooled and pulverized to obtain a molding material.

Example 12

Composition:

a) 4,4'-dicyanamidodiphenylmethane

50 parts by weight

b) N,N'-4,4'-diphenylmethanebismaleimide

30 parts by weight

c) cresol novolak-type epoxy resin

20 parts by weight

d) Hoechst Wax

2 parts by weight

e) carbon black

1 part by weight

f) epoxysilane

2 parts by weight

g) quartz glass powder

250 parts by weight

The above components a) to f) were kneaded by fusion by means of an 20.3 cm mixing roll heated to 80 to 90°C for 3 to 5 min, then cooled and pulverized to obtain a molding material.

The properties of the molding materials obtained in the above Examples 8 to 12 and Conventional Examples 6 to 8 are shown in Table 3. MOS-type IC having electrodes coated with aluminum by vacuum vapor deposition was obtained by transfer molding method in Examples 19 to 26 and Conventional Examples 6 to 8. The resin-sealed MOS-type IC was subjected to a pressure cooker test (PCT; a deterioration test feffected in steam under 2 atm for up to 3000 h) and electricity application PCT (B-PCT; 30 V, up to 500 h) to examine its moisture resistance. Further, the MOS-type IC was subjected to a long time electricity application test at 180°C (180 B-T, 30 V, up to 1000 h) to examine its operating characteristics at high temperatures. The adhesion between the lead wire and the resin molding of the MOS-type IC was examined by immersing the same in the lead checking liquor under an elevated pressure of 10 atm. The results are summarized in Table 4.

The results in Table 4 are represented by the number of breakages in the wiring in PCT or B-PCT and the number of cases of defective operations. The results of the lead check

test were shown according to the following criteria:

| | Proportion of the lead checking liquior penetrated in the void between the lead wire and the resin to a length of the lead wire sealed in the resin |
|---|---|
| A | up to 10% |
| B | 10 to 30% |
| C | 30 to 50% |
| D | 50 to 80% |
| E | 80 to 100% |

Table 3

| | | Example | | | | | Conventional Example | | |
|---|---|---|---|---|---|---|---|---|---|
| | | 8 | 9 | 10 | 11 | 12 | 6 | 7 | 8 |
| Molding properties (170°C) | Spiral flow SF (in) | 25 | 35 | 35 | 30 | 33 | 35 | 45 | 30 |
| | Molding time (min) | 0.5 | 0.6 | 0.6 | 0.5 | 0.5 | 1.5 | 2.5 | 1.5 |
| Properties of cured product (post-curing conditions: 200°C, 5 h) | Coefficient of linear expansion α ($10^{-5}$/°C) | 2.3 | 2.2 | 2.2 | 2.3 | 2.3 | 2.3 | 2.4 | 2.3 |
| | Glass transition temperature Tg (°C) | 225 | 200 | 200 | 220 | 210 | 155 | 150 | 180 |
| | Retension of bending strength after standing at 200°C for 30 days (%) | 97 | 95 | 90 | 95 | 95 | 80 | 75 | 85 |
| | Adhesive power ($kg/cm^2$) | 20 | 25 | 25 | 20 | 25 | 5 | 3 | 5 |
| | Rate of moisture absorption (%) (after 1000 h PCT) | 1.00 | 1.00 | 0.90 | 1.05 | 0.95 | 1.30 | 2.00 | 1.50 |
| | Volume resistivity after 1000 h PCT (Ω-cm) | $1\times10^{15}$ | $8\times10^{14}$ | $9\times10^{14}$ | $1.0\times10^{15}$ | $1.3\times10^{15}$ | $1\times10^{14}$ | $5\times10^{13}$ | $1\times10^{14}$ |
| | Volume resistivity at high temp. (160°C) (Ω-cm) | $1\times10^{14}$ | $8\times10^{13}$ | $1\times10^{14}$ | $1\times10^{14}$ | $7\times10^{13}$ | $3\times10^{11}$ | $4\times10^{12}$ | $5\times10^{12}$ |

(Notes) SF: determined according to EMMI-1-66.

Molding time: the minimum molding time required until the molding can be taken out of the mold without causing any deformation.

α, Tg: determined according to ASTM-D-696.

Adhesive power: shear adhesive power between 42 alloy plate and the resin.

Volume resistivity: determined according to JIS K-6911.

Table 4

| | | Examples | | | | | Conventional Examples | | |
|---|---|---|---|---|---|---|---|---|---|
| | | 8 | 9 | 10 | 11 | 12 | 6 | 7 | 8 |
| PCT (n=100) | 100 h | 0 | 0 | 0 | 0 | 0 | 0 | 0 | 0 |
| | 500 h | 0 | 0 | 0 | 0 | 0 | 0 | 5 | 0 |
| | 1000 h | 0 | 0 | 0 | 0 | 0 | 10 | 60 | 40 |
| | 2000 h | 0 | 0 | 0 | 0 | 0 | 60 | 100 | 70 |
| | 3000 h | 5 | 7 | 3 | 3 | 5 | 100 | - | 100 |
| B-PCT (n=50) | 100 h | 0 | 0 | 0 | 0 | 0 | 3 | 0 | 0 |
| | 300 h | 1 | 0 | 0 | 0 | 0 | 20 | 5 | 3 |
| | 500 h | 3 | 7 | 4 | 3 | 6 | 40 | 25 | 15 |
| 180B-T (n=20) | 100 h | 0 | 0 | 0 | 0 | 0 | 0 | 0 | 0 |
| | 300 h | 0 | 0 | 0 | 0 | 0 | 0 | 0 | 0 |
| | 500 h | 0 | 0 | 0 | 0 | 0 | 10 | 5 | 7 |
| | 1000 h | 0 | 0 | 0 | 0 | 0 | 20 | 10 | 15 |
| Lead check | Initial | A | A | A | A | A | A | A | A |
| | PCT 1000 h | A | A | A | A | A | C | C | C |
| | PCT 1500 h | B | B | A | B | B | E | E | E |

It is apparent from the results shown in Tables 3 and 4 that the molding material of the present invention has a high curing velocity, a high glass transition temperature and an excellent moisture resistance as well as excellent electric characteristics at high temperatures. The molding material is, therefore, suitable for use as the sealing resin for semiconductor devices. Further, the semiconductor device having the resin sealing of the present invention has excellent moisture resistance and operating characteristics at high temperatures and a quite high reliability.

Examples 13 to 19 and Conventional Examples 7 to 11

A MOS 64 K bit D-RAM element was bonded with a tab (a part for carrying the element) of a lead frame (42 alloy) with an adhesive shown in Table 5. Then, the surface of the element was coated with an element surface-protective coating material shown in Table 5. The element was transfer-molded with a sealing material shown in Table 5. Thereafter, moisture resistances (PCT and B-PCT) and semiconductor characteristics (180 B-T) of the molding at a high temperature were examined. The results are shown in Table 5.

Table 5

| | | Example | | | | | | | Conventional Example | | | | |
|---|---|---|---|---|---|---|---|---|---|---|---|---|---|
| | | 13 | 14 | 15 | 16 | 17 | 18 | 19 | 7 | 8 | 9 | 10 | 11 |
| Adhesive | | Ex. 5 | Ex. 5 | Ex. 6 | Ex. 7 | Ex. 7 | Conv. Ex. 5 | Conv. Ex. 4 | Conv. Ex. 3 | Conv. Ex. 4 | Conv. Ex. 3 | Conv. Ex. 3 | Conv. Ex. 4 |
| Surface-protective film | | Ex. 1 | Ex. 3 | Ex. 2 | Conv. Ex. 3 | Ex. 1 | Ex. 2 | Conv. Ex. 1 | Conv. Ex. 1 | Conv. Ex. 2 | Conv. Ex. 1 | Conv. Ex. 2 | Conv. Ex. 1 |
| Resin sealer | | Ex. 8 | Ex. 9 | Ex. 11 | Ex. 10 | Conv. Ex. 8 | Ex. 10 | Ex. 10 | Conv. Ex. 5 | Conv. Ex. 6 | Conv. Ex. 6 | Conv. Ex. 5 | Conv. Ex. 6 |
| PCT (n=150) | 100 h | 0 | 0 | 0 | 0 | 0 | 0 | 0 | 0 | 5 | 0 | 0 | 0 |
| | 500 h | 0 | 0 | 0 | 0 | 0 | 0 | 0 | 30 | 60 | 5 | 10 | 7 |
| | 1000 h | 0 | 0 | 0 | 0 | 0 | 0 | 0 | 150 | 150 | 70 | 90 | 80 |
| | 2000 h | 0 | 0 | 0 | 0 | 0 | 0 | 0 | - | - | 150 | 150 | 150 |
| | 3000 h | 0 | 0 | 0 | 7 | 13 | 2 | 7 | - | - | - | - | - |
| F-PCT (n=50) | 100 h | 0 | 0 | 0 | 0 | 0 | 0 | 0 | 10 | 30 | 5 | 5 | 5 |
| | 300 h | 0 | 0 | 0 | 0 | 0 | 0 | 0 | 50 | 50 | 30 | 40 | 50 |
| | 500 h | 1 | 0 | 2 | 8 | 10 | 3 | 8 | - | - | 50 | 50 | - |
| AOB-T (n=50) | 100 h | 0 | 0 | 0 | 0 | 0 | 0 | 0 | 0 | 0 | 0 | 0 | 0 |
| | 300 h | 0 | 0 | 0 | 0 | 0 | 0 | 0 | 0 | 10 | 0 | 5 | 5 |
| | 500 h | 0 | 0 | 0 | 0 | 0 | 0 | 0 | 20 | 50 | 10 | 40 | 35 |
| | 1000 h | 0 | 0 | 0 | 5 | 3 | 1 | 10 | 50 | - | 40 | 50 | 50 |

It is apparent from Table 5 that the resin-sealed semiconductor device of the present invention in which a combination of the adhesive, element surface-protective film-forming material and sealing material is used has quite excellent moisture resistance and semiconductive characteristics at a high temperature. It is also apparent that even when the element surface-protective film-forming material or sealing material of the present invention is used alone, the moisture resistance and high-temperature semiconductive characteristics superior to those obtained by using a conventional material can be obtained.

What we claim is:

1. A semiconductor device comprising a semiconductor element having a surface-protective film and a resin sealer for sealing the element characterized in that the protective film is made of a polymer containing isomelamine rings and melamine rings.

2. A semiconductor device according to Claim 1 wherein the resin sealer comprises a polymer containing isomelamine rings and melamine rings.

3. A semiconductor device comprising a semiconductor element having a surface-protective film applied to a carrier through an adhesive and a resin sealer for sealing the element, characterized in that the adhesive, surface-protective film and resin sealer each comprise a polymer containing isomelamine rings and melamine rings.

4. A semiconductor device sealed with a resin sealer, characterized in that the sealer comprises a polymer containing isomelamine rings and melamine rings.

5. A process for producing a semiconductor device which comprises coating the surface of a semiconductor element with a resin and hardening the resin by heating to form a protective film on the surface of the semiconductor element, characterized in that a prepolymer obtained by pre-reacting a composition containing a polycyanamide compound and, if necessary, another polymerizable compound is used as

the coating resin and the prepolymer is then hardened by heating.

6. A process for producing a semiconductor device characterized by coating the surface of a semiconductor element with a prepolymer obtained by prereacting a composition containing a polycyanamide compound and, if necessary, another polymerizable compound, hardening the prepolymer by heating to form a protective film on the surface of the semi-conductor element, molding them with a molding material comprising (a) a composition containing a polycyanamide compound and, if necessary, another polymerizable compound or a prepolymer obtained by pre-reacting the composition and (b) an inorganic filler to form a sealed product.

7. A process for producing a semiconductor device characterized by molding a semiconductor element with a molding material comprising (a) a composition containing a polycyanamide compound and, if necessary, another polymerizable compound or a prepolymer obtained by pre-reacting the composition and (b) an inorganic filler to form a sealed product.

1/1

FIG. 1

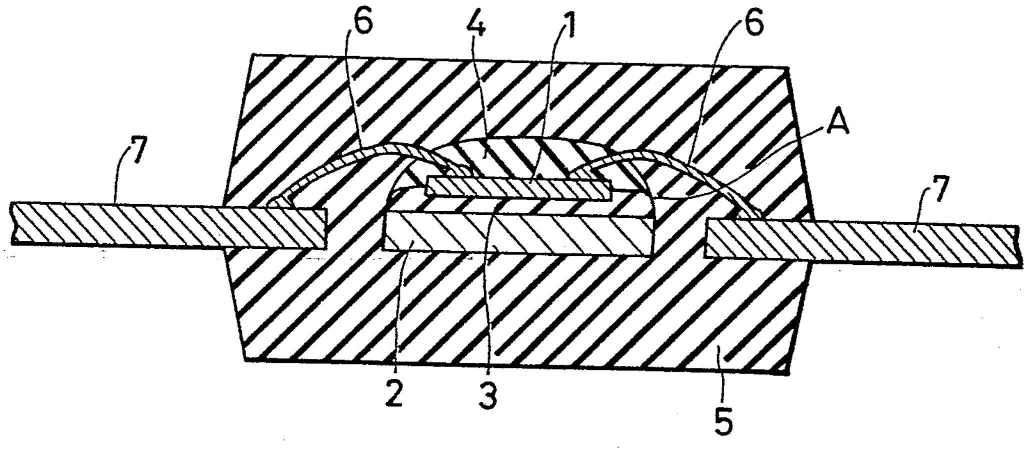


FIG. 2